Europäisches Patentamt

(19) European Patent Office

Office européen des brevets

(11) Veröffentlichungsnummer: **0 030 041**
**B1**

(12) # EUROPÄISCHE PATENTSCHRIFT

(45) Veröffentlichungstag der Patentschrift:
**20.07.83**

(21) Anmeldenummer: **80200742.7**

(22) Anmeldetag: **04.08.80**

(51) Int. Cl.³: **H 01 F 40/06, G 01 R 19/20,
G 01 R 21/00, G 01 R 33/06,
H 01 L 43/08**

(54) **Messwandler zum Messen eines insbesondere von einem Messstrom erzeugten Magnetfeldes.**

(30) Priorität: **27.11.79 CH 10520/79**

(43) Veröffentlichungstag der Anmeldung:
**10.06.81 Patentblatt 81/23**

(45) Bekanntmachung des Hinweises auf die Patenterteilung:
**20.07.83 Patentblatt 83/29**

(84) Benannte Vertragsstaaten:
**DE FR GB IT NL SE**

(56) Entgegenhaltungen:
**AT-B-312 738
DE-B-1 247 398
DE-B-2 263 077
GB-A-2 000 873**

**,,IEEE Transactions on Magnetics'', Bd. MAG-12,
Nr. 6, November 1976, C. H. Bajorek et al. ,,A Permalloy Current Sensor'', S. 813 bis 815.**

(73) Patentinhaber: **LGZ LANDIS & GYR ZUG AG,
Konzern-Patentabteilung, CH-6301 Zug (CH)**

(72) Erfinder: **Lienhard, Heinz, Neufrauenstein 12,
CH-6300 Zug (CH)**
Erfinder: **Schneider, Gernot, Arbach 55a, CH-6340 Baar
(CH)**

## Messwandler zum Messen eines insbesondere von einem Messstrom erzeugten Magnetfeldes

Ein Messwandler der im Oberbegriff des Anspruchs 1 genannten Art ist aus der GB-A Nr. 2000873 bekannt. Der Magnetfeldkomparator dieses Messwandlers besteht aus einem an eine Stromquelle angeschlossenen magnetoresistiven anisotropen Magnetfilm und einer Magnetschicht, die durch eine dünne Isolationsschicht vom Magnetfilm isoliert ist und dazu dient, das magnetische Aussenfeld in unmittelbarer Nähe des Magnetfilms zu konzentrieren und in diesen einzukoppeln. Bei einer ersten Ausführungsform wird das magnetische Aussenfeld in der magnetischen Vorzugsrichtung (leichte Achse) und bei einer zweiten Ausführungsform senkrecht zur magnetischen Vorzugsrichtung (harte Achse) in den Magnetfilm eingekoppelt. Zur Erzeugung eines Vormagnetisierungsfeldes dient eine Flachspule aus Band oder Draht oder eine spiralförmige Spule in der Art einer geätzten gedruckten Schaltung. Der Zeitpunkt der beim Ummagnetisieren des Magnetfilms auftretenden Widerstandsänderung dient als Mass für das zu messende Magnetfeld.

Es ist auch ein linear arbeitender Stromdetektor bekannt ("IEEE Transaction on Magnetics", vol. MAG-12, Nr. 6, November 1976, S. 813 bis 815), der vier zu einer elektrischen Brückenschaltung geschaltete Magnetfilmpaare aus magnetoresistivem Material aufweist. Der zu messende Strom erzeugt ein magnetisches Aussenfeld, das in der harten Magnetachse der Magnetfilme liegt und eine stetige Drehung der Magnetisierung der Magnetfilme über deren weiche Magnetachse hinaus bewirkt. Dadurch ergibt sich innerhalb des nutzbaren Aussteuerungsbereiches eine lineare Abhängigkeit der Widerstände der Magnetfilme und damit der an der Brückenschaltung abgreifbaren Spannung vom zu messenden Strom.

Der Erfindung liegt die Aufgabe zugrunde, das Schaltverhalten des Magnetfeldkomparators des eingangs genannten Messwandlers weiter zu verbessern und einen Aufbau des Messwandlers zu schaffen, der wenig Raum beansprucht und mit modernen Massenproduktionsverfahren bei niedrigen Herstellungskosten realisiert werden kann. Die Erfindung beruht auf der Erkenntnis, dass einerseits eine Aussteuerung des Magnetfilms in dessen leichter Magnetachse besonders vorteilhaft ist und andererseits eine möglichst geringe Länge und Breite des Magnetfilms anzustreben ist, was jedoch aufgrund der nicht beliebig klein wählbaren Schichtdicke des Magnetfilms und des dadurch entstehenden Entmagnetisierungsfeldes nicht ohne weiteres möglich ist.

Bei der im Patentanspruch 1 gekennzeichneten Erfindung werden durch die gegenläufige Rotation der Magnetisierungsvektoren in den beiden Magnetfilmen die Entmagnetisierungsfelder kompensiert, was eine weitestgehende Miniaturisierung der Magnetfilme und damit des ganzen Messwandlers ermöglicht.

Nachfolgend werden einige Ausführungsbeispiele der Erfindung anhand der nicht massstäblich gezeichneten Zeichnungsfiguren näher erläutert. Es zeigen

Fig. 1 eine Prinzipdarstellung eines Messwandlers,

Fig. 2 und 3 Diagramme,

Fig. 4 eine Magnetfilm-Brückenschaltung,

Fig. 5 ein Substrat mit einem Magnetfeldkomparator,

Fig. 6 ein Substrat mit einer Dünnfilmspule,

Fig. 7 einen Messwandler,

Fig. 8 ein Substrat mit einem Magnetfeldkomparator in der Draufsicht,

Fig. 9 die Anordnung nach der Fig. 8 im Schnitt,

Fig. 10 die Anordnung nach der Fig. 8 mit einer Dünnfilmspule in der Draufsicht,

Fig. 11 die Anordnung nach der Fig. 10 im Schnitt,

Fig. 12 und 13 je einen in IC-Technologie hergestellten Messwandler im Schnitt,

Fig. 14 einen Messwandler mit einem Messleiter,

Fig. 15 ein Prinzipschaltbild eines statischen Elektrizitätszählers mit einem Messwandler,

Fig. 16 einen weiteren Messwandler im Schnitt, und

Fig. 17 den Messwandler nach der Fig. 16 in der Draufsicht.

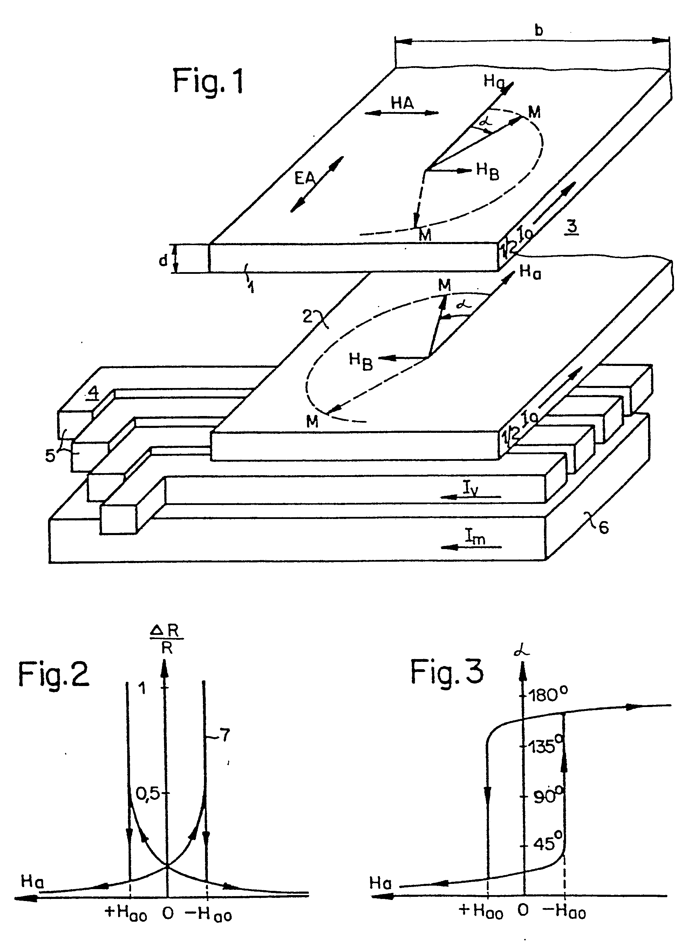

In der Fig. 1 beudeuten 1 und 2 zwei gleichartige, gleich dicke anisotrope Magnetfilme aus ferromagnetischem magnetoresistivem Material, die etwa deckungsgleich in geringem Abstand in zwei zueinander parallelen Ebenen übereinander angeordnet und durch eine nicht gezeichnete nichtmagnetische und elektrisch isolierende oder zumindest schlecht leitende Schicht voneinander getrennt sind und einen Magnetfeldkomparator 3 bilden. Die Magnetfilme 1, 2 sind an eine in der Fig. 1 nicht dargestellte Stromquelle angeschlossen, die einen Strom $I_0$ liefert, so dass jeder der Magnetfilme 1, 2 in seiner Längsrichtung von einem Strom $\frac{1}{2}I_0$ durchflossen wird. Die leichte Magnetachse EA liegt in der Längsrichtung und die harte Magnetachse HA in der Querrichtung der Magnetfilme 1, 2.

In einer weiteren, zu den Magnetfilmen 1, 2 parallelen Ebene ist eine als ebene Dünnfilmspule ausgebildete Magnetspule 4 angeordnet, deren Leiterbahn eine rechteckförmige Spirale bildet, wobei die einzelnen Windungen 5 in jenem Bereich, in welchem sie mit den Magnetfilmen 1, 2 magnetisch gekoppelt sind, parallel zu harten Magnetachse HA angeordnet sind. Die Magnetspule 4 führt einen alternierenden Vormagnetisierungsstrom $I_v$ mit definiertem Kurvenverlauf. Dieser Vormagnetisierungsstrom $I_v$ erzeugt in den Magnetfilmen 1, 2 in Richtung ihrer leichten Magnetachse EA ein Vormagnetisierungsfeld. Wird ausserdem in den Magnetfeldkomparator 3 in Richtung der leichten Magnetachse EA ein zu messendes Magnetfeld eingekoppelt, so entsteht in der leichten Magnetachse EA ein magnetisches

Aussenfeld $H_a$, das der Summe des zu messenden Magnetfeldes und des Vormagnetisierungsfeldes entspricht. Im dargestellten Beispiel wird das zu messende Magnetfeld durch einen Messstrom $I_m$ erzeugt, der in einem Flachleiter 6 in Richtung der harten Magnetachse HA fliesst.

Bei genügend enger magnetischer Kopplung zwischen den Magnetfilmen 1 und 2 erzeugt der im Magnetfilm 2 fliessende Strom $\frac{1}{2} I_o$ in der harten Magnetachse HA des Magnetfilms 1 ein magnetisches Hilfsfeld $H_B$, das in der Fig. 1 nach rechts gerichtet ist. Analog entsteht durch den im Magnetfilm 1 fliessenden Strom $\frac{1}{2} I_o$ in der harten Magnetachse HA des Magnetfilms 2 ein nach links gerichtetes Hilfsfeld $H_B$. Diese Hilfsfelder haben zur Folge, dass bei $H_a = 0$ der Magnetisierungsvektor M der Magnetfilme 1, 2 nicht in der leichten Magnetachse EA liegt, sondern um einen bestimmten Winkel $\alpha$ aus der leichten Magnetachse EA herausgedreht ist. Im Magnetfilm 1 erfolgt diese Drehung des Magnetisierungsvektors M im Uhrzeigersinn und Magnetfilm 2 im Gegenuhrzeigersinn.

Steigt das magnetische Aussenfeld $H_a$ negativ — d.h. entgegengesetzt zur vorangehenden Richtung — an, so wird der Magnetisierungsvektor M vorerst stetig weitergedreht, d.h. der Winkel $\alpha$ nimmt gemäss der Fig. 3, welche die Abhängigkeit des Winkels $\alpha$ vom Aussenfeld $H_a$ zeigt, zu. Nach dem Überschreiten eines Stabilitätspunktes, der nach dem bekannten Stoner-Wohlfahrts-Modell bestimmbar ist, wird der Magnetisierungsvektor M sprungartig, d.h. unabhängig von der Änderungsgeschwindigkeit des Aussenfeldes $H_a$, über die harte Magnetachse HA hinaus weitergedreht und nimmt sehr rasch eine neue, in der Fig. 1 gestrichelt angedeutete Gleichgewichtsposition ein. Hierbei ändern die Magnetfilme 1, 2 ihren ohmschen Widerstand R sprungartig, wie aus der Fig. 2 ersichtlich ist, welche die relative Widerstandsänderung

$$\frac{\Delta R}{R}$$

in Abhängigkeit vom Aussenfeld $H_a$ darstellt. Es entstehen ausgeprägte, steile Schaltspitzen 7, welche sich in einer entsprechenden Änderung der an den Magnetfilmen 1, 2 abfallenden Spannung äussern, leicht detektiert werden können und den Nulldurchgang des Aussenfeldes $H_a$ mit hoher Genauigkeit markieren. Das sprungartige Schalten der Magnetfilme 1, 2 erfolgt zwar nicht exakt im Nulldurchgang des Aussenfeldes $H_a$, sondern bei einer Umschaltfeldstärke $H_{ao}$, d.h. es entsteht eine Hysterese $2 H_{ao}$. Wie im folgenden gezeigt wird, ist jedoch diese Hysterese auch dann ausserordentlich klein, wenn die lateralen Dimensionen der Magnetfilme 1, 2 im Vergleich zur Schichtdicke d nicht sehr gross sind.

Die Hysterese ist abhängig von der Anisotropiefeldstärke $H_K$ und dem in der harten Magnetachse HA der Magnetfilme 1, 2 entstehenden Entmagnetisierungsfeld $H_D$. Denkt man sich den zweiten Magnetfilm 2 als nicht vorhanden und ist die Schichtdicke d des Magnetfilms 1 im Vergleich zur Breite b sehr klein, so ist das Entmagnetisierungsfeld $H_D$ vernachlässigbar und die Hysterese wird im wesentlichen durch die Anisotropiefeldstärke bestimmt; bei grösserer Schichtdicke d ist jedoch das Entmagnetisierungsfeld $H_D$ stark und hat einen wesentlichen Einfluss auf die Hysterese.

Beim beschriebenen Magnetfeldkomparator 3 drehen sich beim Umschalten der Magnetfilme 1, 2 die Magnetisierungsvektoren M, wie bereits erwähnt, im entgegengesetzten Sinn. Sind die beiden Magnetfilme 1, 2 genügend eng gekoppelt, d.h. ist ihr Abstand im Vergleich zu ihrer Breite b genügend klein, so kompensieren sich infolge der gegenläufigen Rotation der Magnetisierungsvektoren M die Entmagnetisierungsfelder $H_D$ in der harten Magnetachse HA weitgehend, so dass praktisch keine die Hysterese vergrössernde Entmagnetisierung auftritt. Der Abstand der Magnetfilme 1, 2 darf aber eine Grenze von etwa 10 nm nicht unterschreiten, damit keine sogenannte *exchange-coupling* auftritt.

Je nach der Grösse des Hilfsfeldes $H_B$ ändern sich sowohl die Hysterese als auch die Form der Schaltspitzen 7. Bei grossem Hilfsfeld $H_B$ ist der Magnetisierungsvektor M dauernd verhältnismässig weit von der leichten Magnetachse EA weggedreht, was sich in einer sehr kleinen Hysterese, jedoch weniger ausgeprägten Schaltspitzen 7 auswirkt, bei kleinem Hilfsfeld $H_B$ ergeben sich besonders ausgeprägte Schaltspitzen und eine grössere Hysterese. Ein optimaler Kompromiss wird erzielt, wenn die Feldstärke des Hilfsfeldes $H_B$ etwa ein Drittel der Anisotropiefeldstärke $H_K$ beträgt.

Wie oben erläutert, ist es beim beschriebenen Magnetfeldkomparator 3 im Gegensatz zum Stand der Technik nicht erforderlich, dass das Verhältnis b/d sehr gross ist. Da die Schichtdicke d praktisch nicht beliebig klein gewählt werden kann, sind beim bekannten Magnetfeldkomparator verhältnismässig grosse Längen- und Breitenabmessungen erforderlich, um die Entmagnetisierung und damit die Hysterese in annehmbaren Grenzen zu halten. Beim beschriebenen Magnetfeldkomparator 3 ist es hingegen möglich, ausserordentlich kleine Magnetfilme 1, 2 mit beispielsweise einer Länge 1 von 10 bis 100 $\mu$ und einer Breite b von 2 bis 20 $\mu$ einzusetzen.

Untersuchungen an einem Magnetfeldkomparator 3 mit

l = 100 $\mu$
b = 20 $\mu$
d = 20 nm
$H_K$ = 480 A/m
$H_B$ = $\frac{1}{3}$ $H_K$ = 160 A/m

haben eine Umschaltfeldstärke $H_{ao} \approx$ 160 A/m ergeben. Würde man den zweiten Magnetfilm 2 weglassen, so ergäbe sich bei gleichbleibenden Abmessungen eine Entmagnetisierungsfeldstärke in der harten Magnetachse und damit eine Umschaltfeldstärke von etwa 1600 A/m.

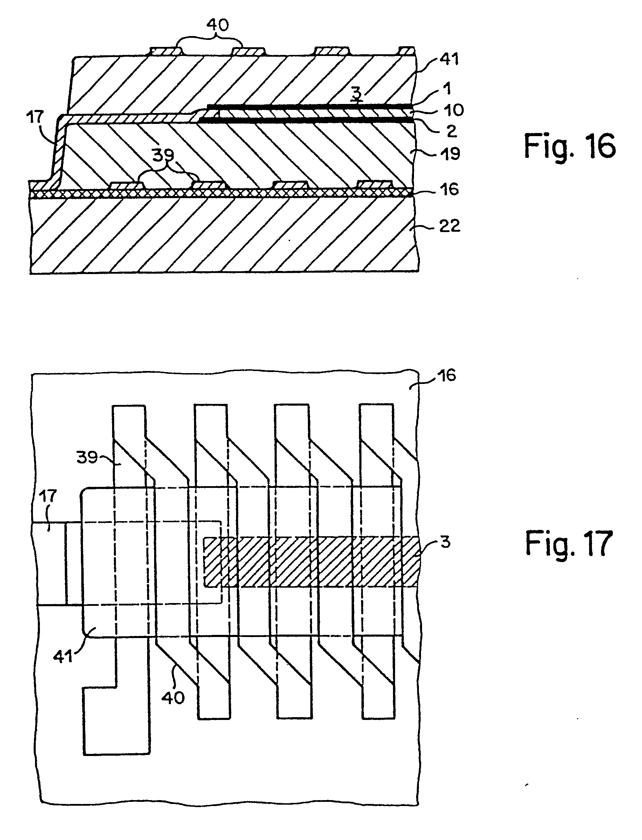

Die geringen Abmessungen der Magnetfilme 1, 2 gestatten, die Magnetspule 4 nach modernen, kostengünstigen Herstellungsverfahren als Dünnfilmspule mit geringer Windungszahl herzustellen. Die Windungen der Dünnfilmspule können in einer gemeinsamen Ebene liegen. Ferner besteht die Möglichkeit, die einzelnen Windungen der Dünnfilmspule in bekannter Weise deckungsgleich übereinander anzuordnen und jeweils durch eine dazwischen liegende Isolationsschicht voneinander zu isolieren. Eine weitere vorteilhafte Ausführungsform einer Dünnfilmspule wird weiter hinten anhand der Fig. 16 und 17 erläutert.

Ausserdem ist es durch die geringen Abmessungen der Magnetfilme 1, 2 und damit der Magnetspule 4 möglich, mit einem verhältnismässig kleinen Vormagnetisierungsstrom $I_v$ auszukommen und trotzdem ein Vormagnetisierungsfeld hoher Feldstärke zu erzeugen, was die Messung starker Magnerfelder ermöglicht.

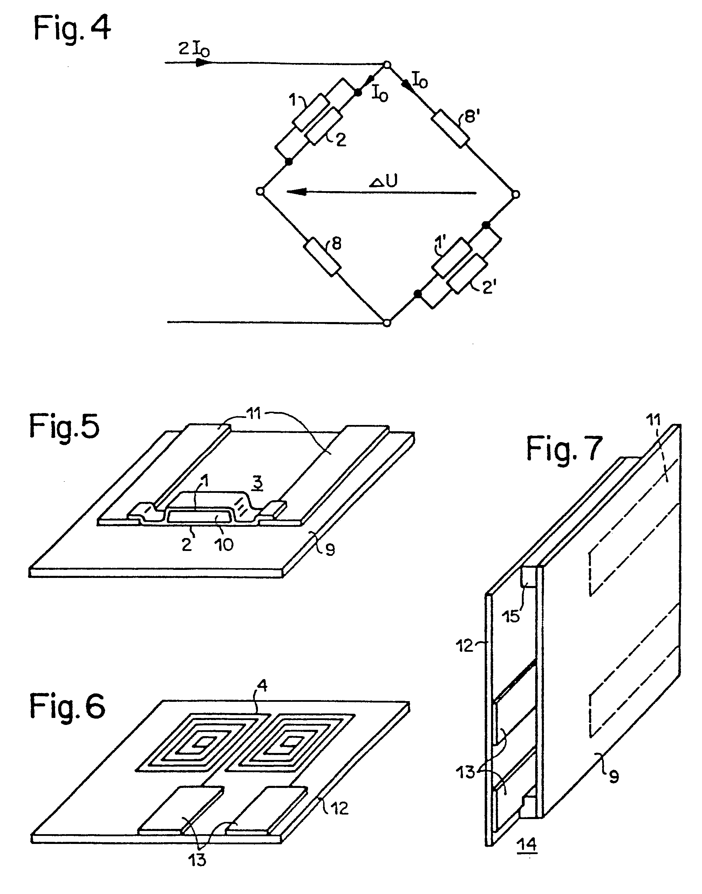

Vorteilhaft bilden gemäss der Fig. 4 das Magnetfilmpaar 1, 2 ein zweites gleichartiges Magnetfilmpaar 1′, 2′ sowie zwei weitere Magnetfilme 8 und 8′ eine elektrische Brückenschaltung. Sind die Widerstände aller vier Brückenglieder im Ruhezustand gleich und wird in die Brückenschaltung ein Strom 2 $I_o$ eingespeist, so entsteht an der Brückendiagonale beim Umschalten der Magnetfilme 1, 2 und 1′, 2′ ein Spannungsimpuls $\Delta U = (\Delta R) \cdot I_o$, während im Ruhezustand die Spannung an der Brückendiagonale null ist. Vorteilhaft bestehen die Magnetfilme 1, 2, 1′, 2′, 8 und 8′ aus dem gleichen Material und werden im selben photolithographischen Arbeitsprozess hergestellt, wobei jedoch die Magnetfilme 1, 2, 1′ und 2′ die Schichtdicke d und die Magnetfilme 8 und 8′ die Schichtdicke 2 d aufweisen. Dadurch wird ein gleichmässiger Temperaturgang sämtlicher Magnetfilme der Brückenschaltung gewährleistet. Ausserdem ist es nicht erforderlich, die Magnetfilme 8 und 8′ gegen das Aussenfeld $H_a$ abzuschirmen, da in diesen kein Hilfsfeld $H_B$ induziert wird und die Entmagnetisierung dominiert, so dass beim Ummagnetisieren der Magnetfilme 8 und 8′ mit den in der Praxis verwendeten Feldstärken keine beachtliche Widerstandsänderung auftritt.

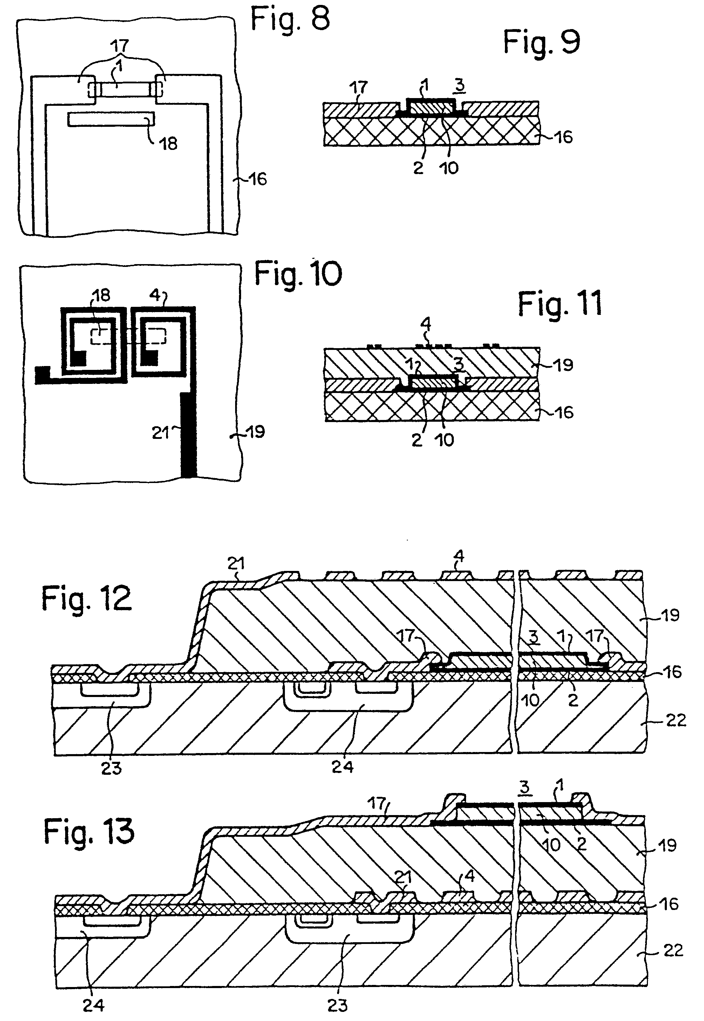

Anhand der Fig. 5 bis 7 wird ein einfaches Ausführungsbeispiel eines Messwandlers erläutert. In der Fig. 5 bedeutet 9 ein Substrat, auf dem der Magnetfeldkomparator 3 mit den beiden Magnetfilmen 1, 2 und einer Isolationsschicht 10 angeordnet ist. Die beiden längsseitigen Enden der Magnetfilme 1, 2 sind je mit einer Leiterbahn 11 verbunden. Die Magnetspule 4 ist auf einem zweiten Substrat 12 angeordnet und im dargestellten Beispiel durch eine Doppelspiralspule gebildet, wobei die äusseren Spiralenden mit je einer Leiterbahn 13 und die inneren Spiralenden, z.B. durch Durchkontaktieren, miteinander verbunden sind. Die Leiterbahnen 11, 13 und die Magnetspule 4 bestehen z.B. aus Gold, Kupfer oder Aluminium. Die Magnetspule 4 wird nach bekannten photolithographischen Dünnfilm-Herstellungsverfahren erzeugt. Zum Auftragen der Leiterbahnen 11, 13 eignen sich Dickfilm- oder Dünnfilm-Herstellungsverfahren. Die beiden Substrate 9 und 12 werden gemäss der Fig. 7 durch Löten, Kleben usw. zu einem festen Block 14 so vereinigt, dass die Enden der Leiterbahnen 11, 13 als Kontakte zugänglich bleiben und der Magnetfeldkomparator 3 in einem definierten Abstand von z.B. einigen Mikron von der Magnetspule 4 an einem Ort zu liegen kommt, wo das Vormagnetisierungsfeld über der magnetisch aktiven Länge der Magnetfilme 1, 2 praktisch konstant ist. Letzteres kann durch einen erhöhten Substratrand 15, durch Einlegen einer Folie oder durch Versenken des Magnetfeldkomparators 3 oder der Magnetspule 4 im Substrat 9 bzw. 12 erfolgen. Der Block 14 kann zusammen mit einem integrierten Schaltkreis (IC), der die erforderlichen elektronischen Komponenten des Messwandlers aufweist, in einem gemeinsamen Gehäuse verkapselt werden, das beispielsweise auf dem Flachleichter 6 (Fig. 1) befestigt werden kann.

Gemäss den Fig. 8 bis 11 können der Magnetfeldkomparator 3 und die Magnetspule 4 auf einem gemeinsamen Substrat 16 angeordnet werden, was vorteilhaft in folgenden Schritten erfolgt:

1. Auf das Substrat 16 wird der Magnetfilm 2 aufgetragen (Fig. 8 und 9).

2. Auf dem Magnetfilm 2 wird die Isolationsschicht 10 deponiert, wobei die Enden des Magnetfilms 2 frei bleiben (Fig. 8 und 9).

3. Analog zu Schritt 1 wird der Magnetfilm 1 aufgebracht (Fig. 8 und 9).

4. Auf das Substrat 16 werden Leiterbahnen 17, welche die Enden der Magnetfilme 1, 2 kontaktieren, sowie eine Rückverbindung 18 für die beiden Spulenhälften der Magnetspule aufgetragen (Fig. 8 und 9).

5. Diese Anordnung wird mit einer Isolationsschicht 19, z.B. aus $SiO_2$, überdeckt, wobei über der Rükverbindung 18 zwei nicht gezeichnete Fenster ausgepart werden (Fig. 10 und 11).

6. Auf die Isolationsschicht 19 wird die Magnetspule 4 mit Anschlussleiterbahnen 21 aufgetragen (Fig. 10 und 11).

Die Schritte 2, 4, 5, und 6 können nach in der IC-Technologie üblichen Verfahren durchgeführt werden. Es ist daher vorteilhaft, den Magnetfeldkomparator 3 und die Magnetspule 4 auf einem Halbleiterplättchen anzuordnen, das einen monolithischen integrierten Schaltkreis mit den erforderlichen elektronischen Komponenten des Messwandlers bildet. Hierbei können die Schritte 2 und 5 mit entsprechenden Isolationsschritten und die Schritte 4 und 6 mit entsprechenden Kontaktierungsschritten bei der Herstellung des integrierten Schaltkreises kombiniert werden, so dass gegenüber der konventionellen Herstellung integrierter Schaltkreise zur Erzeugung des beschriebenen Messwandlers nur die zusätzlichen Schritte 1 und 3 erforderlich sind.

Die Fig. 12 zeigt einen Messwandler mit einem solchen Halbleiterplättchen 22, auf dem der Magnetfeldkomparator 3 und die Magnetspule 4 angeordnet sind. Obwohl die einzelnen Schichten zum Teil eine etwas andere Form als in den Fig. 8 bis 11 aufweisen, sind in der Fig. 12 der besseren Übersichtlichkeit halber Teile, welche die gleiche Funktion wie in den Fig. 8 bis 11 erfüllen, mit den gleichen Bezugszahlen bezeichnet. Das Halbleiterplättchen 22 enthält unter anderem zwei Transistoren 23, 24, von denen der einer über die Leiterbahn 21 mit der Magnetspule 4 verbunden ist und den Vormagnetisierungsstrom $I_v$ (Fig. 1) liefert, während der andere über die Leiterbahn 17 an den Magnetfeldkomparator 3 angeschlossen ist und in diesen den Strom $I_o$ inspeist.

In der Fig. 13 weisen gleiche Bezugszahlen wie in der Fig. 12 auf Teile gleicher Funktion hin. Der Messwandler nach der Fig. 13 unterscheidet sich von jenem nach der Fig. 12 im wesentlichen dadurch, dass die Magnetspule 4 zwischen dem Halbleiterplättchen 22 und dem Magnetfeldkomparator 3 angeordnet ist.

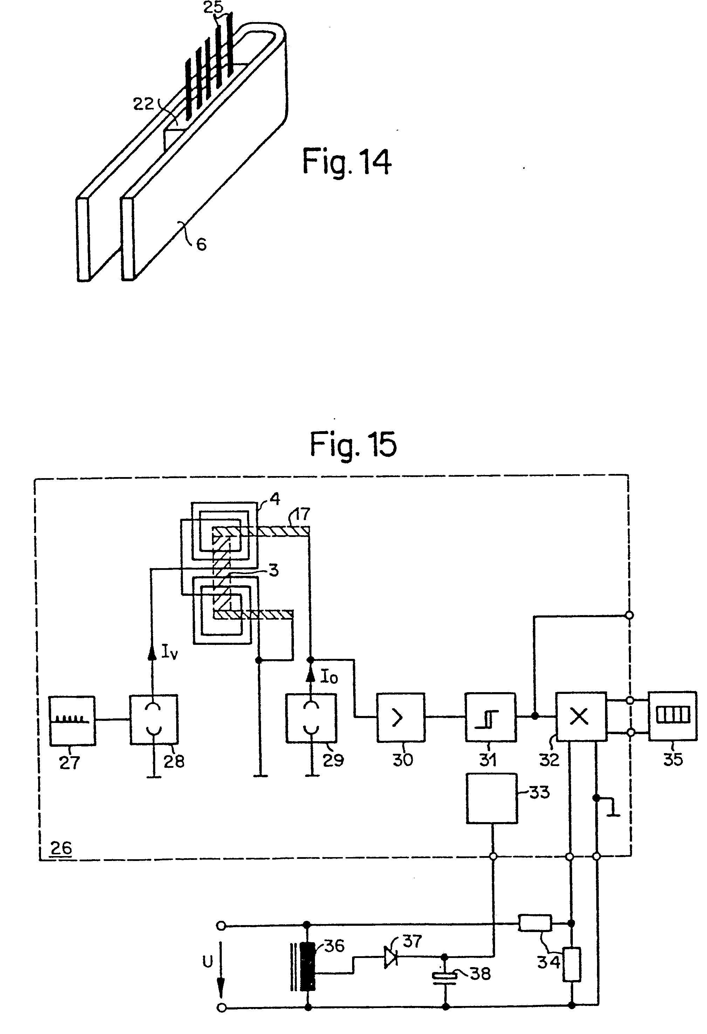

Das Halbleiterplättchen 22 mit dem Magnetfeldkomparator 3 und der Magnetspule 4 kann in konventioneller Weise mit elektrischen Anschlüssen versehen und in ein Gehäuse eingekapselt werden. Hierbei kann der Flachleiter 6 (Fig. 1) ähnlich wie ein Kühlblech eines Leistungstransistors als Teil des Gehäuses dienen. Vorteilhaft ist der Flachleiter 6 gemäss der Fig. 14 U-förmig gebogen und das Halbleiterplättchen 22 zwischen den Schenkeln des Flachleiters 6 angeordnet, wobei die elektrischen Anschlüsse 25 seitlich zwischen den Schenkeln heraustreten. Das durch den Messstrom $I_m$ erzeugte Magnetfeld ist zwischen den Schenkeln des Flachleiters 6 maximal und ausserhalb derselben praktisch null. Durch Auftragen einer weichmagnetischen Schicht auf den Aussenflächen des Flachleiters 6 kann für eine zusätzliche magnetische Abschirmung gesorgt werden.

Die elektrische Prinzipschaltung des durch das Halbleiterplättchen 22 gebildeten integrierten Schaltkreises mit dem Magnetfeldkomparator 3 und der Magnetspule 4 ist in der Fig. 15 innerhalb eines Schaltblockes 26 dargestellt. Dieser Schaltblock 26 enthält eine Oszillator 27, eine Vormagnetisierungsstromquelle 28, eine Gleichstromquelle 29, einen Wechselstromverstärker 30, einen Schwellenschalter 31, einen Multiplikator 32 oder ein anderes analoges oder digitales Signalverarbeitungsglied, ferner einen Speisespannungsstabilisator 33, den Magnetfeldkomparator 3 mit den Leiterbahnen 17 und die Magnetspule 4.

Der Oszillator 27 erzeugt eine Impulsfolge mit konstanter Frequenz, mit der die den Vormagnetisierungsstrom $I_v$ liefernde Vormagnetisierungsstromquelle 28 angesteuert wird. Die Gleichstromquelle 29 speist den Strom $I_o$ in den Magnetfeldkomparator 3. Der Wechselspannungsanteil der über dem Magnetfeldkomparator 3 abfallenden Spannung wird im Wechselspannungsverstärker 30 verstärkt und gelangt zum Schwellenschalter 31, der jeweils praktisch im Nulldurchgang des Aussenfeldes $H_a$ einen Impuls abgibt. Bei definierter Kurvenform des alternierenden Vormagnetisierungsstromes $I_v$ stellen die Zeitpunkte, in denen diese Impulse auftreten, ein Mass dar für den Momentanwert und das Vorzeichen des an den Messwandler angelegten Magnetfeldes bzw. des im Flachleiter 6 fliessenden Stromes. Im Multiplikator bzw. Signalverarbeitungsglied 32 kann aufgrund dieser Zeitpunkte ein den Momentanwert des Stromes darstellendes analoges oder digitales Signal gebildet werden.

Der beschriebene Messwandler eignet sich vorzüglich zur Messung elektricher Energie. Hierzu werden der zu messende Wechselstrom unmittelbar in den Flachleiter 6 eingespeist, gemäss der Fig. 15 die zu messende Wechselspannung U, z.B. über einen Spannungsteiler 34, dem Multiplikator 32 zugeführt und dessen Ausgang an ein Zählwerk 35 angeschlossen. Der Multiplikator 32 bildet das Produkt aus dem Momentanwert des mit dem Messwandler ermittelten Wechselstromes und dem Momentanwert der Wechselspannung und das Zählwerk 35 bildet das Zeitintegral des Produktes.

Zur Speisung des Schaltungsblocks 26 wird die Wechselspannung U mittels eines Transformators 36, eines Gleichrichters 37 und eines Kondensators 38 in eine Kleingleichspannung umgeformt und diese an den Speisespannungsstabilisator 33 angelegt.

Zur Messung elektrischer Energie in einem Drehstromnetz wird vorteilhaft für jede Phase ein Messwandler der beschriebenen Art eingesetzt, wobei die Produktbildung für jede Phase im Multiplikator 32 des Schaltungsblocks 26 der betreffenden Phase oder in einem allen Phasen gemeinsamen Mikrocomputer erfolgen kann.

In den Fig. 16 und 17 weisen gleiche Bezugszahlen wie in den vorangehenden Zeichnungsfiguren wiederum auf Teile gleicher Funktion hin. Die als Dünnfilmspule ausgebildete Magnetspule besteht beim Messwandler nach den Fig. 16 und 17 aus einer ersten Gruppe paralleler, in einer ersten Ebene liegender Leiterbahnen 39 und aus einer zweiten Gruppe paralleler, in einer zweiten Ebene liegender Leiterbahnen 40. Die Leiterbahnen 39 befinden sich unterhalb des Magnetfeldkomparators 3 auf der auf das Halbleiterplättchen 22 aufgetragenen Isolationsschicht 16 und sind vom Magnetfeldkomparator 3 durch die Isolationsschicht 19 isoliert. Oberhalb des Magnetfeldkomparators 3 sind auf einer Isolationsschicht 41 die Leiterbahnen 40 angeordnet. Die Isolationsschichten 19 und 41 bedecken die Leiterbahnen 39 nicht vollständig, sondern lassen deren Enden frei zugänglich. Die beiden Enden der Leiterbahnen 40 sind Z-förmig abgekröpft und jeweils mit einem Ende zweier aufeinanderfolgender Leiterbahnen 39 verbunden. Gegenüber der ebenen Magnetspule 4 weist die aus den Leiterbahnen 39, 40 bestehende Magnetspule bei gleicher Windungszahl eine um ein Vielfaches geringere Leiterlänge auf.

Die in den Magnetfilmen 1, 2 entstehenden Entmagnetisierungsfelder können vollständig eliminiert werden, wenn die beiden Magnetfilme 1, 2 an ihren längsseitigen Rändern miteinander verbunden sind, indem z.B. die Breite b der Isolationsschicht 10 (Fig. 5, 9, 11, 12, 13, 16) etwas kleiner gewählt wird als die Breite b (Fig. 1) der Magnetfilme, so dass in Richtung der harten Magnetachse HA ein geschlossener Pfad für den Magnetfluss vorhanden ist.

## Patentansprüche

1. Messwandler zum Messen eines insbesondere von einem Messtrom ($I_m$) erzeugten Magnetfeldes, mit einer einen alternierenden Vormagnetisierungsstrom ($I_v$) führenden Magnetspule (4; 39, 40) und einem Magnetfeldkomparator (3), der aus einem ersten magnetoresistiven anisotropen Magnetfilm (1) aus ferromagnetischem Material und aus einer Magnetschicht aus ferromagnetischem Material besteht, wobei der Magnetfilm (1) und die Magnetschicht in zwei zueinander parallelen Ebenen übereinander angeordnet, wenigstens annähernd auf ihrer gesamten Breite durch eine nichtmagnetische Isolationsschicht (10) voneinander getrennt und magnetisch eng miteinander gekoppelt sind, wobei ferner der erste Magnetfilm (1) an eine Stromquelle (29) angeschlossen ist und einem magnetischen Aussenfeld ($H_a$), das der Summe des zu messenden Magnetfeldes und dem vom Vormagnetisierungsstrom ($I_v$) erzeugten Vormagnetisierungsfeld entspricht, so ausgesetzt ist, dass der erste Magnetfilm (1) durch das Aussenfeld ($H_a$) in seiner leichten Magnetachse (EA) abwechselnd in beide Sättigungsrichtungen geschaltet wird und jeweils annähernd im Nulldurchgang des Aussenfeldes ($H_a$) seinen elektrischen Widerstand sprungartig ändert, so dass der Zeitpunkt der Widerstandsänderung ein Mass für den Betrag und das Vorzeichen des zu messenden Magnetfeldes darstellt, dadurch gekennzeichnet, dass die Magnetschicht ein zweiter, gleichartiger Magnetfilm (2) ist, der mindestens annähernd gleich dick ist wie der erste Magnetfilm(1), dass die leichte Magnetachse (EA) des zweiten Magnetfilm (2) parallel zur leichten Magnetachse (EA) des ersten Magnetfilms (1) liegt, und dass der zweite Magnetfilm (2) ebenfalls an die Stromquelle (29) angeschlossen ist, so dass der im ersten Magnetfilm (1) fliessende Strom ($\frac{1}{2} I_o$) in der harten Magnetachse (HA) des zweiten Magnetfilms (2) und der im zweiten Magnetfilm (2) fliessende Strom ($\frac{1}{2} I_o$) in der harten Magnetachse (HA) des ersten Magnetfilms (1) ein magnetisches Hilfsfeld ($H_B$) erzeugt und die Magnetisierung (M) der beiden Magnetfilme (1, 2) beim Umschalten des Magnetfeldkomparators (3) im entgegengesetzten Drehsinn sprungartig über die harte Magnetachse (HA) hinaus geschaltet wird, und dass ferner die Magnetspule (4; 39, 40) eine Dünnfilmspule ist.

2. Messwandler nach Anspruch 1, dadurch gekennzeichnet, dass der Magnetfeldkomparator (3) auf einem ersten Substrat (9) und die Magnetspule (4) auf einem zweiten Substrat (12) angeordnet ist, und dass die beiden Substrate (9, 12) zu einem festen Block (14) vereinigt sind (Fig. 5 bis 7).

3. Messwandler nach Anspruch 1, dadurch gekennzeichnet, dass der Magnetfeldkomparator (3) und die Magnetspule (4) auf einem gemeinsamen Substrat (16) angeordnet sind.

4. Messwandler nach Anspruch 1, dadurch gekennzeichnet, dass der Magnetfeldkomparator (3) und die Magnetspule (4) auf einem Halbleiterplättchen (22) angeordnet sind, das einen monolithischen integrierten Schaltkreis (26) bildet.

5. Messwandler nach Anspruch 4, dadurch gekennzeichnet, dass der Schaltkreis (26) eine Vormagnetisierungsstromquelle (28), die an den Magnetfeldkomparator (3) angeschlossene Stromquelle (29), einen Verstärker (30), einen Schwellenschalter (31) und/oder ein digitales oder analoges Signalverarbeitungsglied aufweist.

6. Messwandler nach Anspruch 5, dadurch gekennzeichnet, dass das Signalverarbeitungsglied ein Multiplikator (32) ist.

7. Messwandler nach Anspruch 6, dadurch gekennzeichnet, dass der Messstrom ($I_m$) ein Wechselstrom ist, dass der Schaltkreis (26) einen Multiplikator (32) zur Bildung des Produktes aus dem Momentanwert des mit dem Messwandler ermittelten Messstromes ($I_m$) und dem Momentanwert einer Wechselspannung (U) aufweist, und dass dem Multiplikator (32) ein Zählwerk (35) zur Bildung des Zeitintegrals des Produktes nachgeschaltet ist.

8. Messwandler nach einem der Ansprüche 4 bis 7, dadurch gekennzeichnet, dass das Halbleiterplättchen (22) zwischen den Schenkeln eines U-förmig gebogenen, den Messstrom ($I_m$) führenden Flachleiters (6) angeordnet ist (Fig. 14).

9. Messwandler nach einem der Ansprüche 1 bis 8, dadurch gekennzeichnet, dass die Feldstärke des in der harten Magnetachse (HA) erzeugten magnetischen Hilfsfeldes ($H_B$) annähernd ein Drittel der Anisotropiefeldstärke des ferromagnetischen Materials beträgt.

10. Messwandler nach einem der Ansprüche 1 bis 9, dadurch gekennzeichnet, dass der Magnetfeldkomparator (3) zwei Paare (1, 2; 1', 2') gleichartiger, durch eine nichtmagnetische schlecht leitende Schicht (10) getrennter Magnetfilme sowie zwei weitere Magnetfilme (8, 8') aufweist, und dass die beiden Paare (1, 2; 1', 2') und die beiden weiteren Magnetfilme (8, 8') eine elektrische Brückenschaltung bilden.

11. Messwandler nach einem der Ansprüche 1 bis 10, dadurch gekennzeichnet, dass die Magnetspule aus zwei jeweils in einer Ebene liegenden Gruppen paralleler Leiterbahnen (39, 40) besteht, wobei die Leiterbahnen (39) der einen Gruppe unterhalb und die Leiterbahnen (40) der anderen Gruppe oberhalb des Magnetfeldkomparators (3) angeordnet sind und die beiden Enden der Leiterbahnen (40) der einen Gruppe jeweils mit einem Ende zweier verschiedener Leiterbahnen (39) der anderen Gruppe verbunden sind (Fig. 17).

12. Messwandler nach einem der vorangehenden Ansprüche, dadurch gekennzeichnet, dass die beiden Magnetfilme (1, 2) an ihren längsseitigen Rändern miteinander verbunden sind.

## Claims

1. A measuring transducer for measuring a magnetic fields which is produced in particular by a current to be measured ($I_m$), comprising a mag-

netic coil (4; 39, 40) which carries an alternating bias magnetising current ($I_v$), and a magnetic fields comparator (3) which comprises a first magnetoresistive anisotropic magnetic film (1) comprising ferromagnetic material and a magnetic layer of ferromagnetic material, wherein the magnetic film (1) and the magnetic layer are arranged one above the other in two mutually parallel planes, are separated from each other by a non-magnetic insulating layer (10) at least approximately over their entire width, and are magnetically closely coupled together, wherein in addition the first magnetic film (1) is connected to a current source (29) and is exposed to an external magnetic field ($H_a$) which corresponds to the sum of the magnetic field to be measured, and the bias magnetising field produced by the bias magnetising current ($I_v$), such that the first magnetic film (1) is alternately switched into both directions of saturation by the external field ($H_a$) in its easy magnetic axis (EA) and abruptly changes its electrical resistance approximately whenever the external field ($H_a$) passes through zero, so that the time of the change in resistance represents a measurement in respect of the magnitude and the sign of the magnetic field to be measured, characterized in that the magnetic layer is a second similar magnetic film (2) which is at least approximately of the same thickness as the first magnetic film (1), that the easy magnetic axis (EA) of the second magnetic film (2) is parallel to the easy magnetic axis (EA) of the first magnetic film (1), and that the second magnetic film (2) is also connected to the current source (29) so that the current ($\frac{1}{2} I_o$) flowing in the first magnetic film (1) produces an auxiliary magnetic field ($H_B$) in the hard magnetic axis (HA) of the second magnetic film (2) and the current ($\frac{1}{2} I_o$) flowing in the second magnetic film (2) produces an auxiliary magnetic field ($H_B$) in the hard magnetic axis (HA) of the first magnetic film (1), and the magnetisation (M) of the two magnetic films (1, 2) is abruptly switched beyond the hard magnetic axis (HA) when the magnetic field comparator (3) is switched over in the opposite direction of rotation, and that the magnetic coil (4; 39, 40) is also a thin film coil.

2. A measuring transducer according to claim 1, characterized in that the magnetic field comparator (3) is arranged on a first substrate (9) and the magnetic coil (4) is arranged on a second substrate (12), and that the two substrates (9, 12) are combined to form a fixed block (14) (fig. 5 to 7).

3. A measuring transducer according to claim 1, characterized in that the magnetic field comparator (3) and the magnetic coil (4) are arranged on a common substrate (16).

4. A measuring transducer according to claim 1, characterized in that the magnetic field comparator (3) and the magnetic coil (4) are arranged on a semi-conductor wafer (22) which forms a monolithic integrated circuit (26).

5. A measuring transducer according to claim 4, characterized in that the circuit (26) comprises a bias magnetising current source (28), the current source (29) connected to the magnetic field comparator (3), an amplifier (30), a threshold switch (31) and/or a digital or analog signal processing means.

6. A measuring transducer according to claim 5, characterized in that the signal processing means is a multiplier (32).

7. A measuring transducer according to claim 6, characterized in that the current ($I_m$) to be measured is an alternating current, that the circuit (26) comprises a multiplier (32) for forming the product of the instantaneous value of the current ($I_m$) determined with the measuring transducer and the instantaneous value of an a.c. voltage (U), and that a counter (35) for forming the time integral of the product is disposed on the output side of the multiplier (32).

8. A measuring transducer according to one of claims 4 to 7, characterized in that the semi-conductor wafer (22) is arranged between the limb portions of a flat conductor (6) which is bent into a U-shaped configuration and which carries the current ($I_m$) to be measured (fig. 14).

9. A measuring transducer according to one of claims 1 to 8, characterized in that the field strength of the auxiliary magnetic field ($H_B$) produced in the hard magnetic axis (HA) is approximately one third of the anisotropy field strength of the ferromagnetic material.

10. A measuring transducer according to one of claims 1 to 8, characterized in that the magnetic field comparator (3) comprises two pairs (1, 2; 1', 2') of similar magnetic films which are separated by a non-magnetic poorly conducting layer (10), and two further magnetic films (8, 8'), and that the two pairs (1, 2; 1' 2') and the two further magnetic films (8, 8') form an electrical bridge circuit.

11. A measuring transducer according to one of claims 1 to 10, characterized in that the magnetic coil comprises two groups, each disposed in a respective plane, of parallel conductor tracks (39, 40) wherein the conductor tracks (39) of the one group are arranged below the magnetic field comparator (3) and the conductor tracks (40) of the other group are arranged above the magnetic field comparator (3), and the two ends of the conductor tracks (40) of the one group are respectively connected to ends of two different conductor tracks (39) of the other group (fig. 17).

12. A measuring transducer according to one of the preceding claims, characterized in that the two magnetic films (1, 2) are joined together at their lengthwise edges.

## Revendications

1. Transformateur de mesure, notamment d'un champ magnétique généré par un courant de mesure ($I_v$), comportant une bobine magnétique (4; 39, 40) conduisant un courant de prémagnétisation alternant ($I_v$), et un comparateur de champs magnétiques (3), constitué par une première pellicule magnétique (1) anisotrope magnétorésistive en matériau ferromagnétique et par une couche magnétique en matériau ferromagnétique, tandis que la pellicule magnétique (1) et la couche magnétique sont disposées l'une au-dessus de l'autre dans deux plans parallèles entre eux, sont séparées l'une de l'autre, au moins approximativement sur toute leur largeur, par une couche d'isolement non magnétique (10), et sont couplées entre elles magnétiquement de façon serrée, tandis que, en outre, la première pellicule magnétique (1) est raccordée à une source de courant (29), et est exposée à un champ magnétique extérieur $(H_a)$, qui correspond à la somme du champ magnétique à mesurer et du champ de prémagnétisation engendré par le courant de prémagnétisation $(I_v)$, de telle manière que la première pellicule magnétique (1) soit commutée par le champ extérieur $(H_a)$ dans son axe d'aimantation facile (EA) alternativement dans les deux sens de saturation, et que, au voisinage de chacun des passages par zéro du champ extérieur $(H_a)$, sa résistance électrique varie brusquement, de façon que l'instant du changement de résistance représente une mesure de la valeur et du signe du champ magnétique à mesurer, ledit transformateur de mesure étant caractérisé en ce que la couche magnétique est une seconde pellicule magnétique similaire (2), qui est au moins approximativement de même épaisseur que la première pellicule magnétique (1), en ce que l'axe d'aimantation facile (EA) de la seconde pellicule magnétique (2) s'étend parallèlement à l'axe d'aimantation facile (EA) de la première pellicule magnétique (1), et en ce que la seconde pellicule magnétique (2) est également raccordée à la source de courant (29), de sorte que le courant $(\frac{1}{2} I_o)$ passant dans la première pellicule magnétique (1) engendre un champ magnétique auxiliaire $(H_B)$ dans l'axe d'aimantation difficile (HA) de la seconde pellicule magnétique (2), et que le courant $(\frac{1}{2} I_o)$ passant dans la seconde pellicule magnétique (2) engendre un champ magnétique auxiliaire $(H_B)$ dans l'axe d'aimantation difficile (HA) de la première pellicule magnétique (1), et de sorte que l'aimantation (M) des deux pellicules magnétiques (1, 2), lors de l'inversion du comparateur de champs magnétiques (3), est commutée brusquement dans des sens de rotation opposés, jusqu'au-delà de l'axe d'aimantation difficile (HA), et, de plus, en ce que la bobine magnétique (4; 39, 40) est une bobine à couche mince.

2. Transformateur de mesure suivant la revendication 1, caractérisé en ce que le comparateur de champs magnétiques (3) est disposé sur un premier substrat (9) et la bobine magnétique (4) sur un second substrat (12), et en ce que les deux substrats (9, 12) sont réunis en un bloc rigide (14) (fig. 5-7).

3. Transformateur de mesure suivant la revendication 1, caractérisé en ce que le comparateur de champs magnétiques (3) et la bobine magnétique (4) sont disposés sur un substrat commun (16).

4. Transformateur de mesure suivant la revendication 1, caractérisé en ce que le comparateur de champs magnétiques (3) et la bobine magnétique (4) sont disposés sur une plaquette de semi-conducteurs (22), qui forme un circuit intégré monolithique (26).

5. Transformateur de mesure suivant la revendication 4, caractérisé en ce que le circuit (26) comprend une source de courant de prémagnétisation (28), la source de courant (29) raccordée au comparateur de champs magnétiques (3), un amplificateur (30), un commutateur à seuil (31) et/ou un élément de traitement de signaux numériques ou analogique.

6. Transformateur de mesure suivant la revendication 5, caractérisé en ce que l'élément de traitement de signaux est un multiplicateur (32).

7. Transformateur de mesure suivant la revendication 6, caractérisé en ce que le courant de mesure $(I_m)$ est un courant alternatif, en ce que le circuit (26) présente un multiplicateur (32) pour la formation du produit de la valeur instantanée du courant de mesure $(I_m)$ fourni par le transformateur de mesure et de la valeur instantanée d'une tension alternative (U), et en ce que, à la suite du multiplicateur (32), est monté un compteur (35), pour déterminer l'intégrale du produit dans le temps.

8. Transformateur de mesure suivant l'une des revendications 4 à 7, caractérisé en ce que la plaquette de semi-conducteurs (22) est disposée entre les branches d'un conducteur plat (6) recourbé en forme de U, qui conduit le courant de mesure $(I_m)$ (fig. 14).

9. Transformateur de mesure suivant l'une des revendications 1 à 8, caractérisé en ce que l'intensité du champ auxiliaire magnétique $(H_B)$ généré dans l'axe d'aimantation difficile (HA) est sensiblement égal au tiers de l'intensité de champ d'anisotropie du matériau ferromagnétique.

10. Transformation de mesure suivant l'une des revendications 1 à 9, caractérisé en ce que le comparateur de champs magnétiques (3) présente deux paires (1, 2; 1', 2') de pellicules magnétiques similaires séparées par une couche non magnétique mauvaise conductrice (10), ainsi que deux autres pellicules magnétiques (8, 8'), et en ce que les deux paires (1, 2; 1', 2') et les deux autres pellicules magnétiques (8, 8') forment un circuit en pont électrique.

11. Transformateur suivant l'une des revendications 1 à 10, caractérisé en ce que la bobine magnétique est constituée par deux groupes de bandes conductrices parallèles (39, 40), s'étendant chacun dans un plan, tandis que les bandes conductrices (39) de l'un des groupes sont disposées au-dessous du comparateur de champs magnétique (3), et les bandes conductrices (40) de l'autre groupe, au-dessus de celui-ci, et tandis que les deux extrémités des bandes conductrices (40) de l'un des groupes sont reliées chacune à une extrémité de deux bandes conductrices (39) différentes de l'autre groupe (fig. 17).

12. Transformateur de mesure suivant l'une des revendications précédentes, caractérisé en ce que les deux pellicules magnétiques (1, 2) sont reliées entre elles sur leurs bords longitudinaux.

# Fig. 1

# Fig. 2

# Fig. 3

Fig. 4

$2I_0$

$I_0$

$I_0$

1

2

8'

$\triangle U$

8

1'

2'

Fig. 5

11

1

3

2

10

9

Fig. 6

4

12

13

Fig. 7

11

15

12

13

9

14

Fig. 8

Fig. 9

Fig. 10

Fig. 11

Fig. 12

Fig. 13

Fig. 14

Fig. 15

Fig. 16

Fig. 17